Europäisches Patentamt

European Patent Office

Office européen des brevets

(11) Numéro de publication : **0 442 548 B1**

(12) **FASCICULE DE BREVET EUROPEEN**

(45) Date de publication du fascicule du brevet :
**02.08.95 Bulletin 95/31**

(51) Int. Cl.$^6$ : **H03M 7/40,** H04N 7/32,
G06F 5/06

(21) Numéro de dépôt : **91200109.6**

(22) Date de dépôt : **21.01.91**

(54) **Dispositifs de codage et de décodage à longueur variable de signaux numériques.**

(30) Priorité : **30.01.90 FR 9001068
15.05.90 FR 9006035**

(43) Date de publication de la demande :
**21.08.91 Bulletin 91/34**

(45) Mention de la délivrance du brevet :
**02.08.95 Bulletin 95/31**

(84) Etats contractants désignés :
**DE FR GB**

(56) Documents cités :
**EP-A- 0 033 672
EP-A- 0 090 137
EP-A- 0 314 356
US-A- 4 394 774
US-A- 4 663 660
US-A- 4 907 101
PATENT ABSTRACTS OF JAPAN, vol. 12, no.
489 (E-696)[3336], 21 décembre 1988; &
JP-A-63 204 923 (FUJITSU LTD) 24-08-1988
PATENT ABSTRACTS OF JAPAN, vol. 13, no.
518 (E-848)[3866], 20 novembre 1989; & JP-A-1
209 819 (NTT) 23-08-1989
SMPTE JOURNAL, vol. 96, no. 9, septembre
1987, pages 834-836, New York, US; R.C. BRAI-
NARD et al.: "Two TV signals on a 45 Mbit/sec
channel"**

(73) Titulaire : **LABORATOIRES D'ELECTRONIQUE
PHILIPS
22, Avenue Descartes
F-94450 Limeil-Brévannes (FR)**

(84) **FR**
Titulaire : **Philips Electronics N.V.
Groenewoudseweg 1
NL-5621 BA Eindhoven (NL)**

(84) **DE GB**

(72) Inventeur : **Le Queau, Marcel
Société Civile S.P.I.D.,
156, Boulvard Haussmann
F-75008 Paris (FR)**
Inventeur : **Lhuillier, Jean-Jacques
Société Civile S.P.I.D.,
156, Boulvard Haussmann
F-75008 Paris (FR)**

(74) Mandataire : **Landousy, Christian et al
Société Civile S.P.I.D.
156, Boulevard Haussmann
F-75008 Paris (FR)**

## Description

La présente invention concerne un dispositif de codage à longueur variable de signaux numériques répartis dans N voies en parallèle, comprenant dans chaque voie successivement des moyens de quantification, des moyens de codage à longueur variable et des moyens de régulation de débit incluant des mémoires-tampons, et également un dispositif de décodage correspondant.

La communication "A flexible architecture for a HDTV codec based on DCT", de M.Barbero, S.Cucchi et J.L. Hernando-Bailon, volume III du document "Proceedings of the Third International Workshop on HDTV", Turin (Italie), 30 août-1er septembre 1989, décrit un système de codage destiné à permettre une réduction de débit des informations à transmettre et dans lequel sont prévues N voies de codage à longueur variable en parallèle, précédées d'un démultiplexeur des signaux d'entrée et suivies d'un multiplexeur prévu pour délivrer les signaux de sortie du dispositif.

Avant de préciser les possibilités et les limites d'un tel dispositif, il est utile d'effectuer quelques rappels relatifs aux opérations de codage dans une chaîne de transmission de signaux numériques à débit fixe après codage à longueur variable. Le brevet des Etats-Unis d'Amérique n°4 394 774 décrit un exemple de réalisation de dispositif de codage à longueur variable permettant une telle transmission. Il apparaît, notamment sur la figure 2 de ce brevet, que le dispositif décrit comprend successivement un circuit de transformation cosinus discrète, un circuit de normalisation, un circuit de quantification, un circuit à codage variable, et un circuit de régulation de débit délivrant d'une part des signaux de régulation renvoyés vers le circuit de quantification et d'autre part les signaux de sortie, à débit fixe, du dispositif de codage. Par souci de simplification de la description d'un tel dispositif, on convient d'englober dans une même appellation de "circuit de quantification" le sous-ensemble qui exécute les fonctions de transformation cosinus, de normalisation et de quantification, et c'est cette description simplifiée que l'on retiendra ci-après.

Dans un dispositif de codage ainsi constitué, les signaux à transmettre dans le canal de transmission traversent donc d'abord le circuit de quantification. La sortie de ce circuit est codée dans le circuit de codage à longueur variable, et le résultat de ce codage est envoyé dans la mémoire-tampon du circuit de régulation de débit. En sortie de celui-ci, le canal de transmission extrait à fréquence fixe les signaux numériques stockés dans ladite mémoire-tampon. En même temps, le pas de quantification est commandé par l'état de remplissage de cette mémoire-tampon de façon que celle-ci ne soit jamais ni totalement pleine ni totalement vide : le pas est augmenté quand elle risque d'être trop pleine, et est au contraire réduit quand elle se vide trop. Pour que cette opération de régulation puisse se dérouler correctement, il faut bien entendu que la mémoire-tampon ait au moins une valeur donnée de capacité de mémorisation, qu'on appellera par la suite C, ou capacité minimale de stockage.

Le fonctionnement d'un tel dispositif de codage ne pose pas de problème, sauf lorsque la technologie de réalisation dont on dispose est limitée en fréquence et que la fréquence voulue est supérieure à cette limite. D'une manière générale, ce problème est actuellement résolu de la façon suivante. Lorsqu'il y a un rapport N entre la fréquence théorique maximale voulue pour le dispositif et la fréquence maximale réelle que l'on peut mettre en oeuvre technologiquement, la solution technique apportée consiste à démultiplexer les signaux d'entrée et les diriger vers N voies en parallèle. Ces N voies sont identiques et indépendantes, et fonctionnent chacune comme le dispositif de codage décrit ci-dessus, mais cette fois avec une fréquence de fonctionnement compatible avec la technologie. C'est une telle structure à N voies en parallèle qui est décrite dans le premier document cité.

On appelle $F_{max}$ la fréquence maximale réellement utilisable, dans chacune des N voies, pour faire fonctionner une telle structure, $NF_{max} = F_{MAX}$ la fréquence maximale voulue pour le dispositif de codage, et NC la capacité minimale de stockage qui serait indispensable, pour la mémoire-tampon du circuit de régulation de débit, dans le cas d'une structure classique en série devant fonctionner à la fréquence $F_{MAX}$. Dans le cas d'une structure à N voies en parallèle, la capacité minimale de stockage de la mémoire-tampon prévue dans chacune des N voies peut théoriquement être ramenée à $NC/N = C$ puisque la fréquence de fonctionnement, $F_{max}$, est N fois plus faible.

En pratique, il n'est malheureusement pas possible d'adopter une telle valeur, car on constate qu'on ne peut pas effectuer avec N mémoires-tampon de capacité C une régulation de débit équivalente à celle que permet une mémoire-tampon unique de capacité NC. On observe en effet qu'après démultiplexage et codage à longueur variable dans chacune des N voies, les informations ainsi codées peuvent être très inégalement réparties entre ces voies et, par conséquent, entre les N mémoires-tampons. A la limite, la totalité des informations codées pourrait être concentrée sur une seule voie, les (N-1) autres voies et leurs mémoires-tampons n'étant alors plus d'aucune utilité. Cela implique que, pour réaliser effectivement la fonction de régulation de débit, chacune des N mémoires-tampons doit avoir une capacité minimale de stockage égale à NC, et non C comme on aurait pu le croire. Il en résulte que la mémoire-tampon équivalente du dispositif de codage a une capacité de stockage égale à N x N x C = N²C, c'est-à-dire que cette capacité doit être N fois plus grande que dans le cas d'une structure série équivalente où la valeur de la capacité de stockage est NC.

Un premier but de l'invention est de remédier à cet inconvénient en proposant un dispositif de codage qui permette d'obtenir de façon simple, pour une structure à N voies en parallèle de codage à longueur variable, une capacité minimale de stockage voisine de celle de la structure série équivalente.

A cet effet, l'invention concerne un dispositif de codage caractérisé en ce qu'il comprend également, entre lesdits moyens de codage à longueur variable et lesdits moyens de régulation de débit, des moyens d'aiguillage prévus pour envoyer, après un classement des signaux codés selon leurs longueurs croissantes ou décroissantes et un classement des mémoires-tampons selon leurs états de remplissage décroissant ou croissant, les signaux codés les plus longs vers les mémoires-tampons les moins remplies, et pour ajouter aux signaux codés un indicateur de rang indiquant leur origine.

Dans un mode particulier de réalisation, dans lequel le dispositif de codage comprend successivement un circuit de démultiplexage de la séquence des signaux d'entrée en N sous-séquences présentes sur N sorties en parallèle dudit circuit, N voies en parallèle pour le codage à longueur variable desdites N sous-séquences respectivement, et un circuit de multiplexage des N sous-séquences de signaux ainsi codés présentes en sorties desdites N voies, lesdites voies comprenant elles-mêmes chacune un circuit de quantification des signaux d'entrée de la voie, un circuit de codage à longueur variable des signaux ainsi quantifiés, et un circuit de régulation de débit associant à une mémoire-tampon une connexion de rétroaction reliant ladite mémoire et le circuit de quantification, ce dispositif comprend également :

(A) en sortie du sous-ensemble de codage constitué par les N circuits de codage à longueur variable, un circuit de classement des signaux codés en fonction de leur longueur ;

(B) en sortie du sous-ensemble de régulation de débit constitué par les N circuits de régulation de débit, un circuit de classement des mémoires-tampons selon leur état de remplissage ;

(C) entre ledit sous-ensemble de codage et ledit sous-ensemble de régulation de débit, un circuit d'aiguillage prévu pour envoyer, en réponse à un circuit de commande, le signal codé correspondant à la longueur de signal codé la plus faible à l'entrée de mémoire correspondant à la mémoire-tampon la plus remplie, le signal codé correspondant à la longueur de signal codé la plus grande à l'entrée de mémoire correspondant à la mémoire-tampon la moins remplie, et, de même, chacun des signaux codés correspondant à des longueurs de signal codé de plus en plus grandes à respectivement chacune des entrées de mémoire correspondant à des mémoires-tampons de moins en moins remplies ;

(D) en sortie du sous-ensemble de codage, entre celui-ci et ledit circuit d'aiguillage, un sous-ensemble de retardement comprenant un circuit à retard par voie et destiné à assurer le synchronisme des signaux codés avec les commandes d'aiguillage qui leur correspondent.

Avec cette réalisation, il est alors possible et avantageux de ne prévoir qu'une seule connexion de rétroaction, reliant l'une quelconque des mémoires-tampons à chacun des circuits de quantification.

Un autre but de l'invention est de proposer un dispositif de décodage à longueur variable qui soit capable, lorsque des signaux numériques ont subi un codage à longueur variable tel que celui décrit ci-dessus, d'assurer un décodage efficace et correct des signaux ainsi codés.

A cet effet, l'invention concerne un dispositif de décodage à longueur variable dans N voies de décodage en parallèle comprenant chacune successivement des moyens de mémorisation suivis de moyens de décodage à longueur variable puis de moyens de quantification inverse, ledit décodage concernant des signaux numériques préalablement codés à longueur variable dans N voies de codage en parallèle comprenant chacune successivement des moyens de quantification, des moyens de codage à longueur variable, des moyens de régulation de débit incluant des mémoires-tampons, ainsi que, entre lesdits moyens de codage à longueur variable et lesdit moyens de régulation de débit, des moyens d'aiguillage des signaux codés vers des mémoires-tampons d'autant moins remplies que les signaux codés sont plus longs, caractérisé en ce que lesdits signaux codés sont regroupés par blocs de données accompagnés respectivement d'un indicateur de rang desdits blocs, et en ce que ledit dispositif de décodage comprend également, en sortie desdits moyens de quantification inverse, des moyens d'aiguillage desdits blocs en fonction de l'indicateur de rang qui leur est respectivement associé.

Dans un mode particulier de réalisation, dans lequel le dispositif de décodage comprend successivement un circuit de démultiplexage de la séquence des signaux d'entrée en N sousséquences présentes sur N sorties en parallèle dudit circuit, ainsi que N voies en parallèle pour le décodage à longueur variable desdites sousséquences respectivement, lesdites voies comprenant elles-mêmes chacune une mémoire-tampon de stockage des signaux d'entrée de la voie, un circuit de décodage à longueur variable des signaux ainsi quantifiés, et un circuit de quantification inverse des signaux ainsi décodés, ce dispositif de décodage est plus spécialement caractérisé en ce que lesdits moyens d'aiguillage comprennent :

(a) un circuit de commutation à N commutateurs à une entrée et N sorties, dont les N positions respectives sont déterminées à l'aide de N éléments de transcodage de l'indicateur de rang associé à chaque bloc ;

(b) un circuit de transcodage regroupant lesdits éléments de transcodage ;

(c) entre les N entrées desdits moyens d'aiguillage et les N entrées respectives dudit circuit de commutation, un circuit de retard à N éléments à retard associés respectivement à chaque voie ;

(d) un circuit de multiplexage à N entrées reliées respectivement à l'une des N sorties desdits commutateurs, ledit circuit étant prévu pour délivrer une séquence continue de blocs ordonnés selon l'indicateur de rang qui leur était respectivement associé.

Les particularités et avantages de l'invention ainsi proposée apparaîtront de façon plus détaillée dans la description qui suit ainsi que dans les dessins annexés, donnés à titre d'exemples non limitatifs et dans lesquels :

- la figure 1 montre un exemple particulier de réalisation d'un dispositif de codage selon l'invention ;
- la figure 2a montre un extrait de la séquence continue des signaux se présentant à l'entrée du dispositif de codage de la figure 1, sous la forme de blocs (numérotés ici à partir de 1) séparés à intervalles réguliers par des mots spéciaux M, la figure 2b montre les N séquences de blocs correspondantes, à fréquence N fois plus faible, à l'entrée des N voies en parallèle du dispositif de codage, et la figure 2c montre, en correspondance aux N séquences de blocs de longueur déterminée de la figure 2b, un exemple de N séquences correspondantes de signaux codés à longueur variable ;
- la figure 3 montre un exemple particulier de réalisation des circuits essentiels du dispositif de codage de la figure 1, dans le cas de quatre voies en parallèle, c'est-à-dire pour N = 4, et la figure 4 montre un exemple de réalisation de la commande de position d'un commutateur quelconque $S_x$ dans ce cas de quatre voies en parallèle ;
- la figure 5 montre un exemple particulier de réalisation d'un dispositif de décodage selon l'invention ;
- la figure 6 montre un extrait de la séquence continue des signaux se présentant à l'entrée du dispositif de décodage de la figure 5 ;
- la figure 7 montre un exemple de réalisation du circuit d'aiguillage du dispositif de décodage de la figure 5.

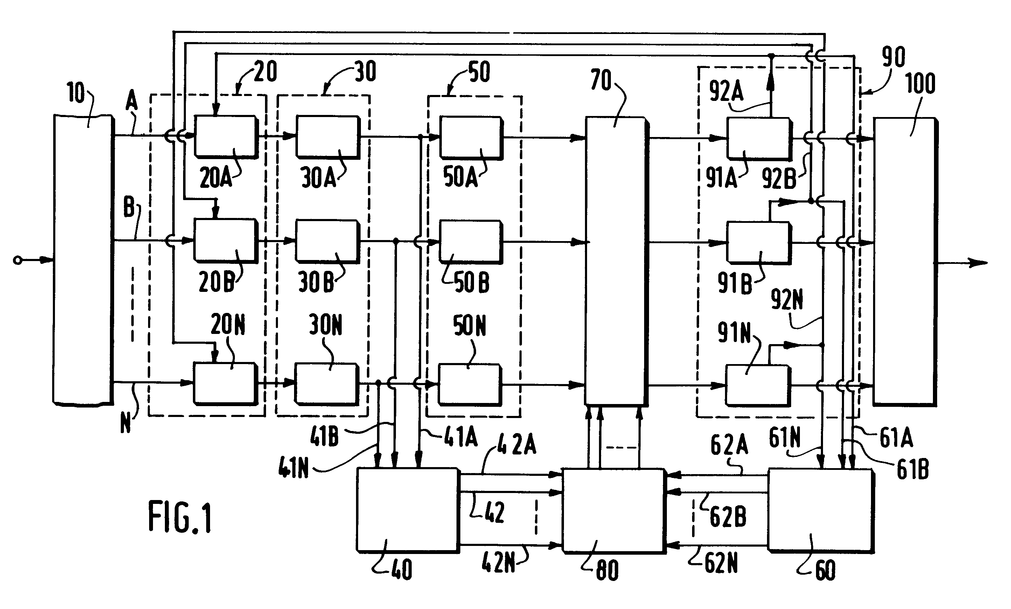

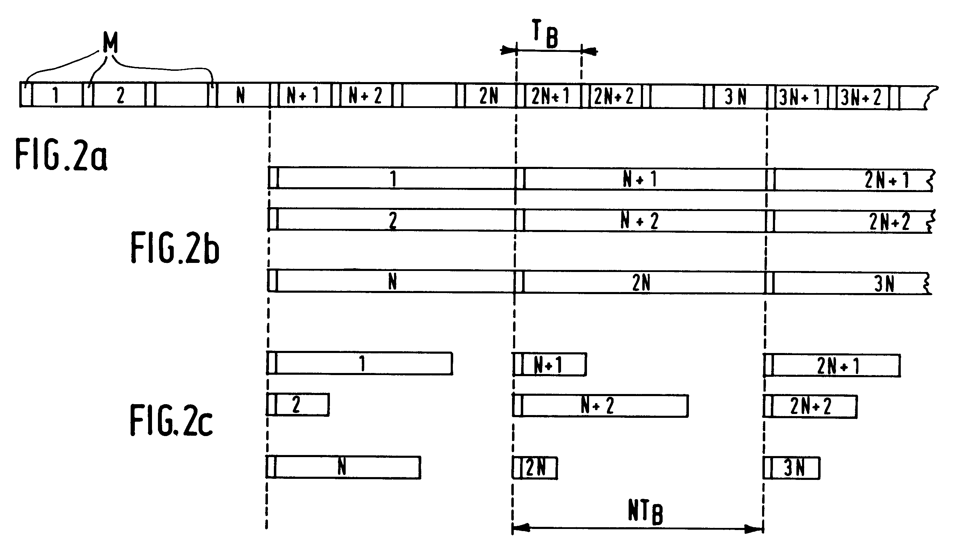

Le dispositif de codage représenté sur la figure 1 et délivrant des signaux codés tels que ceux traités par le dispositif de décodage selon l'invention décrit plus loin comprend, dans le cas de cet exemple, les éléments suivants. Un circuit de démultiplexage 10 reçoit tout d'abord les signaux d'entrée du dispositif de codage. Ces signaux d'entrée, qui, à l'origine, se présentent sous la forme d'un flot continu de bits, sont préalablement séparés à intervalles réguliers par des mots spéciaux découpant ce flot en blocs de longueur fixe. Dans le cas du codage de signaux de télévision, on découpe la séquence continue des signaux par exemple en blocs de huit lignes d'image consécutives. Ces blocs se succèdent donc à l'entrée du circuit de démultiplexage 10 à une fréquence notée $F_m$ à laquelle correspond une période $T_B$. En sortie du circuit 10, ces mêmes blocs apparaissent démultiplexés sur N voies A à N distinctes, à la fréquence $F_m/N$, avec une période $NT_B$. La figure 2a montre la séquence continue des blocs 1, 2,..., N, N+1, N+2,..., 2N, 2N+1, 2N+2,..., 3N, 3N+1,..., etc..., séparés à intervalles réguliers par les mots spéciaux M, et la figure 2b montre les N séquences correspondantes à fréquence N fois plus faible présentées à l'entrée des N voies en parallèle.

Ces N voies en parallèle, référencées A à N, comprennent chacune un circuit de quantification, 20A à 20N respectivement, le regroupement de ces N circuits constituant un sous-ensemble de quantification 20 (qui exécute comme indiqué plus haut, mais ici dans chaque voie, les fonctions traditionnelles de transformation cosinus, de normalisation et de quantification). Chaque circuit de quantification 20A à 20N reçoit respectivement l'une des N séquences disponibles à l'entrée des N voies et représentées sur la figure 2b : le circuit de quantification 20A reçoit par exemple la séquence constituée des blocs de rang 1, N+1, 2N+1, 3N+1,..., etc..., qui est présente à l'entrée de la première voie, le circuit 20B reçoit la séquence des blocs 2, N+2, 2N+2, 3N+2, etc..., présente à l'entrée de la deuxième voie, et ainsi de suite.

Dans chaque voie, le circuit de quantification est suivi d'un circuit de codage à longueur variable, 30A à 30N respectivement, le regroupement de ces N circuits constituant un sous-ensemble 30 de codage à longueur variable. Chaque circuit 30A à 30N reçoit les signaux quantifiés délivrés par le circuit de quantification respectivement associé et délivre des mots codés à longueur variable correspondant à chaque bloc de longueur fixe. La figure 2c montre, en correspondance aux N séquences de blocs de longueur déterminée et fixe de la figure 2b, un exemple de N séquences correspondantes de signaux codés à longueur variable.

Chaque sortie des circuits de codage à longueur variable 30A à 30N est alors envoyée :

(a) d'une part sur une entrée respective d'un circuit 40 de classement des signaux codés selon leur longueur, par exemple selon les longueurs croissantes, à ces N entrées notées 41A à 41N du circuit 40 correspondant N sorties 42A à 42N qui indiquent respectivement le rang de chaque voie tel qu'il ressort du classement ici effectué ;

(b) d'autre part sur une entrée respective d'un sous-ensemble de retardement 50 constitué de N lignes à retard 50A à 50N, le retard de ces lignes étant tel que le classement effectué par le circuit 40 est établi avant que les signaux codés en provenance du sous-ensemble de codage à longueur variable 30 n'apparaissent en sortie desdites lignes à retard.

De façon sensiblement simultanée avec le classement opéré par le circuit 40, un circuit 60 de classement de voies opère un classement des N voies A à N selon les états de remplissage de N mémoires-tampons 91A à 91N respectivement associées et constituant le dernier circuit de chaque voie. L'ordre du classement (états de remplissage décroissant) est inverse de celui choisi pour le classement de longueurs décrit précédemment. Les signaux de sortie indiquant les N états de remplissage correspondant aux N mémoires des voies A à N sont respectivement fournis aux N entrées 61A à 61N du circuit de classement 60 dont les sorties 62A à 62N indiquent respectivement le rang des voies A à N tel qu'il ressort du classement d'états de remplissage effectué. Le retard des lignes 50A à 50N est choisi de telle façon que le classement effectué par le circuit 60 soit terminé avant que les signaux codés en provenance du sous-ensemble de codage à longueur variable 30 n'apparaissent en sortie des lignes à retard 50A à 50N.

Le sous-ensemble de retardement 50 est suivi d'un circuit d'aiguillage 70 effectuant un aiguillage de N voies vers N voies, puis de N circuits de régulation de débit (91A, 92A) à (91N, 92N) constituant un sous-ensemble 90 de régulation de débit. Chacun de ces circuits de régulation de débit est, comme précédemment, situé dans l'une des N voies en parallèle et comprend ladite mémoire-tampon 91A à 91N respectivement, ainsi qu'une connexion de rétroaction 92A à 92N respectivement, destinée à agir sur le circuit de quantification associé, selon l'état de remplissage de la mémoire-tampon correspondante.

L'aiguillage de N voies vers N voies effectué par le circuit 70 est réalisé de la façon suivante. On associe en amont de l'aiguilleur les voies véhiculant les blocs de longueurs les plus grandes aux voies en aval de l'aiguilleur associées aux mémoires-tampons dont les états de remplissage sont les plus faibles. Plus précisément, on relie, par l'une des N connexions du circuit 70, celle des sorties du sous-ensemble 50 qui correspond à la longueur de bloc codé la plus longue à celle des entrées du sous-ensemble 90 qui correspond à la mémoire-tampon dont l'état de remplissage est le plus faible, puis on relie, par une autre connexion, la sortie du sous-ensemble 50 correspondant à la longueur de bloc codé la plus courte à la mémoire-tampon dont l'état de remplissage est le plus élevé, et, de même entre ces deux connexions extrêmes, on relie les (N-2) connexions restantes du sous-ensemble 50 aux (N-2) entrées des mémoires-tampons restantes en associant deux à deux les longueurs de signal codé croissantes (ou respectivement décroissantes) et les mémoires-tampons de moins en moins remplies (ou respectivement de plus en plus).

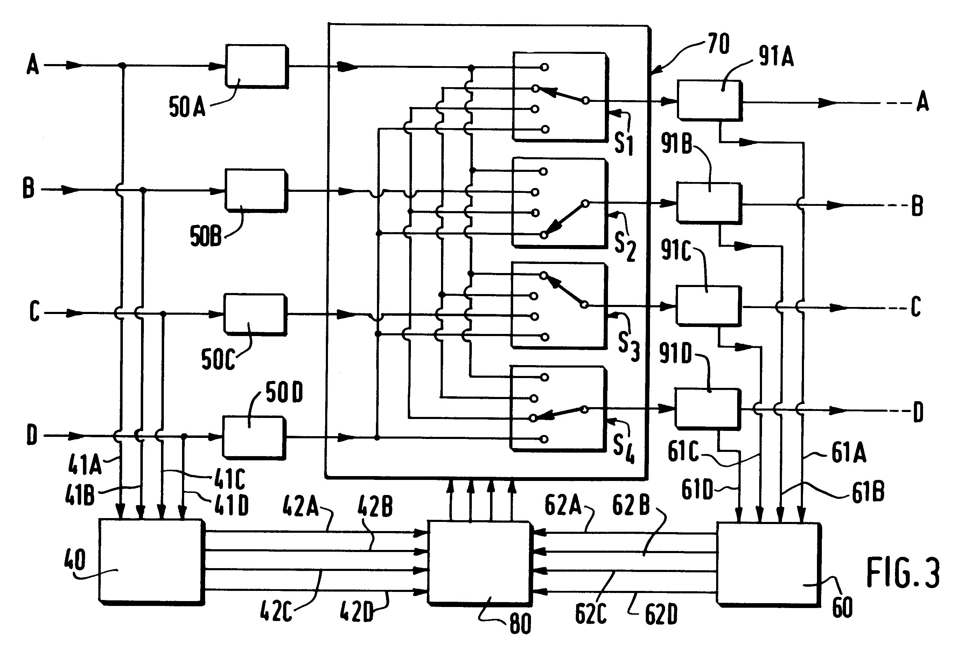

L'aiguillage est donc commandé d'une part par le classement de longueurs effectué par le circuit 40 et d'autre part par le classement de mémoires-tampons effectué par le circuit 60, par l'intermédiaire d'un circuit de commande 80. On précise ici une façon de réaliser cet aiguillage en donnant en référence à la figure 3 un exemple concret dans lequel N est égal à 4. Comme indiqué sur cette figure 3, le circuit d'aiguillage 70 est constitué de quatre commutateurs $S_1$, $S_2$, $S_3$ et $S_4$, ayant quatre positions chacun. Soit par exemple 4, 3, 1, 2 le classement respectif des voies A, B, C, D en amont du circuit d'aiguillage suivant les longueurs de blocs croissantes et 3, 2, 4, 1 le classement de ces mêmes voies en aval du circuit d'aiguillage suivant les états de remplissage décroissant des mémoires-tampons associées à ces voies. D'après ce qui a été dit précédemment, on déduit que la voie amont A doit être connectée à la voie aval C, la voie amont B à la voie aval A, la voie amont C à la voie aval D, et la voie amont D à la voie aval B. Ces quatre connexions entre voies amont et aval sont indiquées dans le tableau 1 en fonction du classement de celles-ci :

### TABLEAU 1

| Classement | Voies amont | Voies aval |
|:---:|:---:|:---:|
| 1 | C | D |
| 2 | D | B |
| 3 | B | A |
| 4 | A | C |

et schématisées par les positions des quatre commutateurs représentées sur la figure 3. Bien entendu, ce tableau 1 peut aussi se mettre sous la forme du tableau 2 suivant :

## TABLEAU 2

| Position commutateur | Numéro commutateur |
|:---:|:---:|
| 2 | 1 |
| 4 | 2 |
| 1 | 3 |
| 3 | 4 |

En effet, dans l'exemple décrit, pour établir les quatre connexions correctes conformément aux classements de longueurs et d'états de remplissage effectués respectivement en amont et en aval du circuit d'aiguillage, il faut que le commutateur $S_2$ soit sur la position 4, le commutateur $S_4$ sur la position 3, le commutateur $S_3$ sur la position 1, et le commutateur $S_1$ sur la position 2.

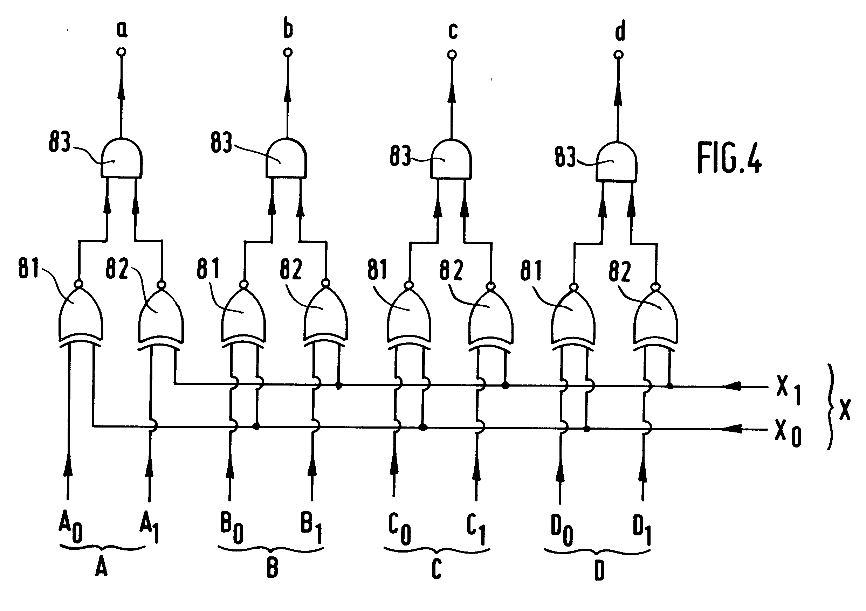

Une réalisation possible de la commande de position d'un commutateur quelconque $S_x$ est schématisée sur la figure 4. Les entrées $A_0$, $B_0$, $C_0$, $D_0$ de quatre circuits OU-exclusif 81 correspondent respectivement aux bits de poids faible du classement des voies amont A, B, C, D, et les entrées $A_1$, $B_1$, $C_1$, $D_1$ de quatre autres circuits OU-exclusif 82 aux bits de poids fort. Les entrées $X_0$ et $X_1$ correspondent respectivement aux bits de poids faible et de poids fort du classement de la voie aval X. La table de vérité du schéma logique, complété par quatre portes ET 83, est telle qu'il apparaît le niveau logique "1" sur l'une des quatre sorties a, b, c, d correspondant respectivement aux positions 1, 2, 3, 4 du commutateur $S_x$, et le niveau logique "0" sur les trois autres. Comme le niveau logique "1" indique laquelle des quatre voies amont A, B, C, D a le même classement que la voie aval X, il est clair que la position de ce niveau logique "1" commande directement la position du commutateur.

Dans l'exemple décrit correspondant à N = 4, le circuit de commande 70 est constitué de quatre dispositifs logiques identiques à celui décrit sur la figure 4, puisqu'il y a quatre commutateurs à commander. Il en découle de manière générale que, dans le cas de N voies, ce dispositif 70 peut être réalisé à l'aide de N dispositifs logiques identiques constitués chacun de N portes "ET" et de (M x N) circuits logiques "OU EXCLUSIF", M étant le nombre de bits nécessaire pour indiquer, en base 2, le classement d'une voie.

Bien entendu, tout en associant ainsi N blocs codés et classés selon leurs longueurs mesurées croissantes (ou décroissantes) à N mémoires-tampons classées inversement selon leurs états de remplissage décroissant (ou respectivement croissant), on veille cependant à conserver une sorte d'indicateur d'origine du bloc, par exemple en inscrivant dans ou à côté de chaque bloc le numéro de la sortie du circuit de démultiplexage 10 dont il provient. Cette information relative à l'indication d'origine de chaque bloc va en effet être indispensable du côté réception et décodage, comme le montre la suite de la description, pour reconstruire la séquence de sortie des signaux numériques décodés, et doit donc être transmise en même temps que les signaux concernant le bloc lui-même. Ladite transmission de signaux de sortie de chaque voie et de ces indications d'origine du contenu de chaque mémoire-tampon est assurée de façon séquentielle, après regroupement de la totalité de ces informations, à l'aide d'un circuit de multiplexage 100.

Avec la structure de dispositif de codage ainsi décrite, les informations codées se trouvent donc également réparties entre les N mémoires-tampons, et ce quelle que soit la répartition d'origine sur les N sorties du circuit de démultiplexage 10. Dans le cas ici décrit, mais non limitatif, d'une extraction séquentielle de données de ces N mémoires-tampons, effectuée par interrogation à un rythme régulier, on démontre que la différence entre leurs états de remplissage à un instant donné ne peut pas excéder la longueur L d'un bloc codé. Il en résulte que la capacité minimale de stockage de chacune des mémoires-tampons du dispositif de codage est maintenant égale à C+L, c'est-à-dire voisine de C, alors qu'elle était égale à NC avec la solution antérieure à la présente invention. Il résulte également de cette similitude des états de remplissage qu'une seule connexion de rétroaction peut alimenter les N circuits de quantification pour assurer de façon effective la réalisation de la régulation de débit, puisque toutes les mémoires-tampons se trouvent maintenant dans des états de remplissage identiques ou très voisins.

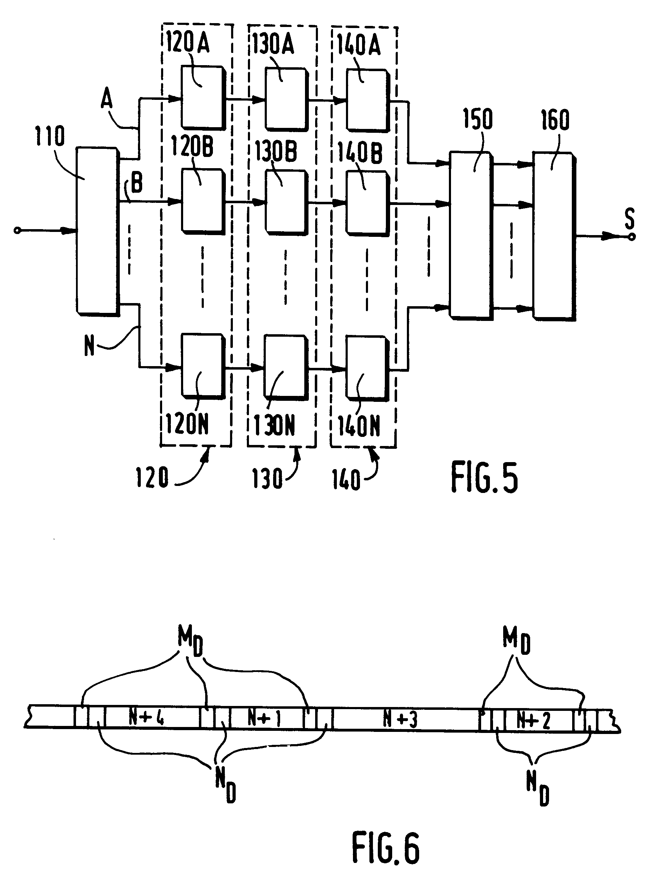

Réciproquement, lorsque des signaux numériques ont subi un codage à longueur variable du type de celui qui vient d'être décrit, il importe d'assurer de façon correcte le décodage des signaux ainsi codés tout en minimisant la capacité de mémoire-tampon nécessaire au cours de ce décodage. Le dispositif de décodage représenté sur la figure 5 dans un exemple particulier de réalisation permet d'atteindre cet objectif. Ce dispositif comprend, dans le cas de cet exemple, les éléments suivants. Un circuit de démultiplexage 110, réalisant l'opération inverse de celle effectuée par le circuit de multiplexage 100, reçoit les signaux numériques préalablement codés. Ces signaux d'entrée se présentent sous la forme d'un flot continu de bits agencés en mots de code de longueur variable décrivant les blocs. Comme indiqué sur la figure 6, ces blocs (ici par exemple N+4, N+1, N+3, N+2,...) sont séparés les uns des autres par des mots spéciaux $M_D$ correspondant aux mots M de la figure 2a, et chaque mot $M_D$ est suivi du numéro $N_D$ de la sortie du circuit de démultiplexage 10 dont il provient, dans le dispositif de codage.

En sortie du circuit de démultiplexage 110, ces signaux d'entrée sont répartis sur N voies A à N distinctes et en parallèle. Ces N voies, prévues pour exécuter les opérations inverses de celles effectuées par les voies A à N du dispositif de codage de la figure 1, comprennent d'abord chacune une mémoire-tampon, 120A à 120N respectivement, le regroupement de ces N mémoires constituant un sous-ensemble de mémorisation 120. On démontre que l'on rend minimale la capacité de ce sous-ensemble de mémorisation lorsque le circuit de démultiplexage 110 réalise l'opération inverse de celle effectuée par le circuit de multiplexage 100 du dispositif de codage.

Chaque mémoire-tampon est suivie d'un circuit de décodage à longueur variable, 130A à 130N respectivement, le regroupement de ces N circuits constituant un sous-ensemble 130 de décodage à longueur variable. Chacun de ces circuits est lui-même suivi d'un circuit de quantification inverse, 140A à 140N respectivement, le regroupement de ces N circuits constituant un sous-ensemble de quantification inverse 140 qui exécute dans chaque voie les opérations inverses de celles opérées dans les sous-ensembles correspondants des N voies de codage, à savoir : quantification inverse, normalisation inverse, transformation cosinus discrète inverse. Ces opérations de décodage à longueur variable sont décrites dans le brevet US-A-4394774 déjà cité, et ne seront pas davantage rappelées ici.

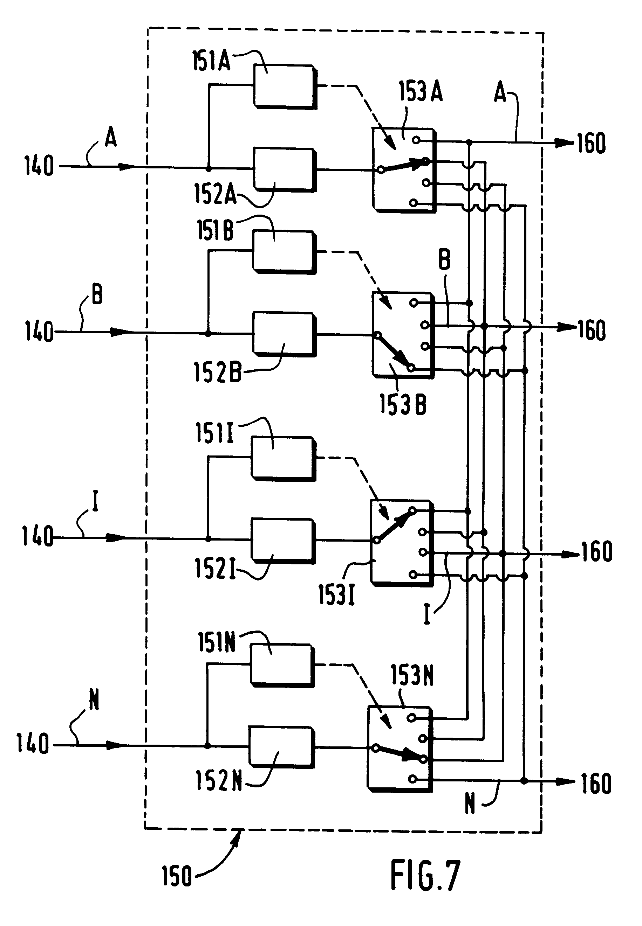

Chaque sortie des circuits de quantification inverse 140A à 140N est alors envoyée vers un circuit d'aiguillage 150 effectuant un aiguillage de N voies vers N voies et réalisé de la façon suivante. Comme indiqué sur la figure 7, à l'entrée de ce circuit d'aiguillage, pour chaque voie A à N, un circuit de transcodage composé d'éléments de transcodage 151A, 151B,..., 151I,..., 151N extrait des données le numéro de la sortie du circuit de démultiplexage 10 du dispositif de codage de laquelle provient le bloc qui suit ce numéro. A partir de ce numéro constituant un indicateur du rang du bloc dans la séquence des signaux d'origine, le circuit de transcodage (151A, 151B,..., 151I, ..., 151N) détermine la position de commutateurs correspondants 153A, 153B,... 153I, ..., 153N formant un circuit de commutation. Cette détermination de position est faite de façon telle que le bloc suivant chaque numéro soit aiguillé vers la voie portant le même indice A, B,..., I ,... N que celle empruntée par le bloc à la sortie du circuit de démultiplexage 10 (le numéro correspondant directement à la position du commutateur). Un circuit de retard composé d'éléments à retard 152A, 152B,... 152I,..., 152N permet de retarder les données de la durée nécessaire pour que la position des commutateurs 153A, 153B,..., 153I,..., 153N ait été déterminée et occupée.

Chacune des N sorties du circuit d'aiguillage 150 est finalement envoyée sur l'entrée correspondante d'un circuit de multiplexage 160, dont la sortie S délivre les signaux de sortie du dispositif de décodage.

## Revendications

1. Dispositif de codage à longueur variable de signaux numériques répartis dans N voies en parallèle, comprenant dans chaque voie successivement des moyens de quantification, des moyens de codage à longueur variable et des moyens de régulation de débit incluant des mémoires-tampons, caractérisé en ce qu'il comprend également, entre lesdits moyens de codage à longueur variable et lesdits moyens de régulation de débit, des moyens d'aiguillage prévus pour envoyer, après un classement des signaux codés selon leurs longueurs croissantes ou décroissantes et un classement des mémoires-tampons selon leurs états de remplissage décroissant ou croissant, les signaux codés les plus longs vers les mémoires-tampons les moins remplies, et pour ajouter aux signaux codés un indicateur de rang indiquant leur origine.

2. Dispositif de codage à longueur variable selon la revendication 1, comprenant successivement un circuit de démultiplexage de la séquence des signaux d'entrée en N sous-séquences présentes sur N sorties en parallèle dudit circuit, N voies en parallèle pour le codage à longueur variable desdites N sousséquences respectivement, et un circuit de multiplexage des N sous-séquences de signaux ainsi codés présentes en sorties desdites N voies, lesdites voies comprenant elles-mêmes chacune un circuit de quantification des signaux d'entrée de la voie, un circuit de codage à longueur variable des signaux ainsi quantifiés, et un circuit de régulation de débit associant à une mémoire-tampon une connexion de rétroaction reliant ladite mémoire et le circuit de quantification, caractérisé en ce qu'il comprend :

(A) en sortie du sous-ensemble de codage constitué par les N circuits de codage à longueur variable, un circuit de classement des signaux codés en fonction de leur longueur ;
(B) en sortie du sous-ensemble de régulation de débit constitué par les N circuits de régulation de débit, un circuit de classement des mémoires-tampons selon leur état de remplissage ;
(C) entre ledit sous-ensemble de codage et ledit sous-ensemble de régulation de débit, un circuit d'aiguillage prévu pour envoyer, en réponse à un circuit de commande, le signal codé correspondant à la longueur de signal codé la plus faible à l'entrée de mémoire correspondant à la mémoire-tampon la plus remplie, le signal codé correspondant à la longueur de signal codé la plus grande à l'entrée de mémoire correspondant à la mémoire-tampon la moins remplie, et, de même, chacun des signaux codés correspondant à des longueurs de signal codé de plus en plus grandes à respectivement chacune des entrées de mémoire correspondant à des mémoires-tampons de moins en moins remplies ;
(D) en sortie du sous-ensemble de codage, entre celui-ci et ledit circuit d'aiguillage, un sous-ensemble de retardement comprenant un circuit à retard par voie et destiné à assurer le synchronisme des signaux codés avec les commandes d'aiguillage qui leur correspondent.

3. Dispositif de codage selon la revendication 2, caractérisé en ce que le sous-ensemble de régulation de débit ne comprend qu'une seule connexion de rétroaction, reliant l'une quelconque des mémoires-tampons à chacun des circuits de quantification.

4. Dispositif de décodage à longueur variable dans N voies de décodage en parallèle comprenant chacune successivement des moyens de mémorisation suivis de moyens de décodage à longueur variable puis de moyens de quantification inverse, ledit décodage concernant des signaux numériques préalablement codés à longueur variable dans N voies de codage en parallèle comprenant chacune successivement des moyens de quantification, des moyens de codage à longueur variable, des moyens de régulation de débit incluant des mémoires-tampons, ainsi que, entre lesdits moyens de codage à longueur variable et lesdit moyens de régulation de débit, des moyens d'aiguillage des signaux codés vers des mémoires-tampons d'autant moins remplies que les signaux codés sont plus longs, caractérisé en ce que lesdits signaux codés sont regroupés par blocs de données accompagnés respectivement d'un indicateur de rang desdits blocs, et en ce que ledit dispositif de décodage comprend également, en sortie desdits moyens de quantification inverse, des moyens d'aiguillage desdits blocs en fonction de l'indicateur de rang qui leur est respectivement associé.

5. Dispositif de décodage à longueur variable selon la revendication 4, comprenant successivement un circuit de démultiplexage de la séquence des signaux d'entrée en N sous-séquences présentes sur N sorties en parallèle dudit circuit, ainsi que N voies en parallèle pour le décodage à longueur variable desdites sous-séquences respectivement, lesdites voies comprenant elles-mêmes chacune une mémoire-tampon de stockage des signaux d'entrée de la voie, un circuit de décodage à longueur variable des signaux ainsi quantifiés, et un circuit de quantification inverse des signaux ainsi décodés, caractérisé en ce que lesdits moyens d'aiguillage comprennent :
(a) un circuit de commutation à N commutateurs à une entrée et N sorties, dont les N positions respectives sont déterminées à l'aide de N éléments de transcodage de l'indicateur de rang associé à chaque bloc ;
(b) un circuit de transcodage regroupant lesdits éléments de transcodage ;
(c) entre les N entrées desdits moyens d'aiguillage et les N entrées respectives dudit circuit de commutation, un circuit de retard à N éléments à retard associés respectivement à chaque voie ;
(d) un circuit de multiplexage à N entrées reliées respectivement à l'une des N sorties desdits commutateurs, ledit circuit étant prévu pour délivrer une séquence continue de blocs ordonnés selon l'indicateur de rang qui leur était respectivement associé.

## Patentansprüche

1. Vorrichtung zur variablen Längen-Kodierung digitaler Daten, die auf N Parallelleitungen verteilt werden, wobei in jeder Leitung nacheinander Folgendes eingeschlossen ist : Vorrichtungen zur Quantifikation, Vorrichtungen zur variablen Längen-Kodierung und Vorrichtungen zur Regulierung der Übertragungsgeschwindigkeit, einschließlich Pufferspeicher; dadurch charakterisiert, daß sie außerdem Folgendes einschließen : zwischen den besagten Vorrichtungen für die Kodierung mit variabler Länge und den besagten Vorrichtungen für die Übertragungsgeschwindigkeitsregulierung Verteilungsvorrichtungen, die dazu vorgesehen sind - nach einer Klassifikation der kodierten Signale entsprechend deren zu- oder abnehmender Länge und einer Klassifikation der Pufferspeicher entsprechend ihrer ab- oder zunehmenden Füllzustände - die längsten kodierten Signale zu den am wenigsten gefüllten Pufferspeichern zu leiten, sowie zur Hinzufügung eines Rangstellenindikators an die kodierten Signale, der deren Herkunft angibt.

2. Vorrichtung zur variablen Längen-Kodierung gemäß Patentanspruch 1, die nacheinander Folgendes enthält: eine Schaltung zur Demultiplexierung der Eingangssignalsequenz in N Teilsequenzen, die an N Parallelausgängen der besagten Schaltung anwesend sind, sowie N Parallelleitungen für die jeweilige variable Längen-Kodierung der besagten N Teilsequenzen, sowie eine Multiplexierschaltung für die N Teilsequenzen der so kodierten Signale, die an den Ausgängen der besagten N Leitungen anwesend sind, wobei die besagten Leitungen ihrerseits jede eine Quantifikationsschaltung für die Eingangssignale der Leitung enthalten, sowie eine Schaltung zur variablen Längen-Kodierung der so quantifizierten Signale und eine Schaltung zur Regulierung der Übertragungsgeschwindigkeit; wobei einem Pufferspeicher eine Feedback-Datenkopplung zugeordnet ist, die den besagten Pufferspeicher und die Quantifikationsschaltung wieder verbindet; dadurch charakterisiert, daß sie Folgendes einschließt :

(A) am Ausgang des Kodierungsteilsystems, das von den N Schaltungen zur variablen Längen-Kodierung gebildet wird, eine Schaltung zur Klassifikation der kodierten Signale in Abhängigkeit zu deren Länge;

(B) am Ausgang des Teilsystems zur Regulierung der Übertragungsgeschwindigkeit, das von den N Schaltungen der Übertragungsgeschwindigkeitsregulierung gebildet wird, eine Schaltung zur Klassifikation der Pufferspeicher nach deren Füllzustand;

(C) zwischen dem besagten Teilsystem für die Kodierung und dem besagten Teilsystem für die Übertragungsgeschwindigkeitsregulierung eine Verteilungsschaltung, die vorgesehen ist, um in Beantwortung einer Steuerschaltung das kodierte Signal mit der kürzesten Länge zum Speichereingang des am meisten gefüllten Pufferspeichers zu schicken und das kodierte Signal mit der größten Länge zum Speichereingang des am wenigsten gefüllten Pufferspeichers zu schicken, und außerdem ein jedes der kodierten Signale entsprechend seiner zunehmend größeren Länge jeweils an die entsprechenden Speichereingänge der zunehmend weniger gefüllten Pufferspeicher zu schicken;

(D) am Ausgang des Kodierungsteilsystems, zwischen diesem selbst und der besagten Verteilungsschaltung, ein Verzögerungs-Teilsystem, welches pro Leitung eine Verzögerungsschaltung enthält, und das dazu bestimmt ist, die Synchronität der kodierten Signale mit den Verteilungssteuerungen, die ihnen entsprechen, zu gewährleisten.

3. Vorrichtung zur Kodierung, gemäß Patentanspruch 2, die dadurch charakterisiert wird, daß das Teilsystem für die Regulierung der Übertragungsgeschwindigkeit nicht mehr als eine einzige Feedback-Datenkopplung enthält, die irgendeinen der Pufferspeicher mit jeder der Quantifikationsschaltungen wieder verbindet.

4. Vorrichtung zur variablen Längen-Dekodierung in N parallelen Dekodierungsleitungen, die jede nacheinander Folgendes enthält: Vorrichtungen zur Speicherung, denen Vorrichtungen zur Dekodierung mit variabler Länge folgen und außerdem Vorrichtungen für die umgekehrte Quantifikation. Die besagte Dekodierung betrifft die numerischen Signale, die vorher in variabler Länge in N parallelen Kodierungsleitungen kodiert worden sind. Diese Kodierungsleitungen enthalten jede nacheinander Vorrichtungen zur Quantifikation, Vorrichtungen zur variablen Längen-Kodierung, Vorrichtungen zur Regulierung der Übertragungsgeschwindigkeit (welche die Pufferspeicher einschließen). Außerdem enthalten sie zwischen den besagten Vorrichtungen der variablen Längen-Kodierung und den besagten Vorrichtungen der Regelung der Übertragungsgeschwindigkeit Vorrichtungen zur Verteilung der kodierten Signale auf die Pufferspeicher, die umso weniger gefüllt sind je länger die kodierten Signale sind. Dies wird dadurch charakterisiert, daß die besagten kodierten Signale in Datenblöcken gruppiert werden, die jeweils von einem Rangstellenindikator begleitet werden. Außerdem enthält die besagte Dekodierungsvorrichtung jeweils am Ausgang der besagten Vorrichtungen der umgekehrten Quantifikation Verteilungsvorrichtungen für die besagten Blöcke in Abhängigkeit vom Rangstellenindikator, der ihnen jeweils zugeordnet ist.

5. Vorrichtung zur variablen Längen-Dekodierung gemäß Patentanspruch 4, die nacheinander eine Demultiplexierschaltung für die Eingangssignalsequenz in N Teilsequenzen enthält, die auf N parallelen Ausgängen der besagten Schaltung vorhanden sind, sowie N Parallelleitungen jeweils für die variable Längen-Dekodierung dieser besagten Teilsequenzen. Die besagten Leitungen selbst enthalten jede einen Pufferspeicher zur Speicherung der Eingangssignale der Leitung, eine Schaltung zur variablen Längen-Dekodierung der so quantifizierten Signale, sowie eine Schaltung für die umgekehrte Quantifikations der so dekodierten Signale; dadurch charakterisiert, daß die besagten Verteilungsvorrichtungen Folgendes einschließen :

(a) einen Schaltkreis mit N Schaltern an einem Eingang und N Ausgängen, deren N jeweilige Positionen jeweils mit Hilfe von N Umkodierungselementen des Rangstellenindikators bestimmt werden, der jedem Block beigeordnet ist;

(b) eine Umkodierungsschaltung, die die besagten Umkodierungselemente neu gruppiert;

(c) eine Verzögerungsschaltung mit N der jeweiligen Leitung zugeordneten Verzögerungselementen, die sich zwischen den N Eingängen der besagten Verteilungsvorrichtungen und den N jeweiligen Eingängen des besagten Schaltkreises befinden;

(d) eine Multiplexierschaltung mit N Eingängen, die jeweils an einen der N Ausgänge der besagten Schalter angeschlossen ist, wobei die besagte Schaltung dazu vorgesehen ist, eine kontinuierliche Sequenz von Blöcken zu liefern, die gemäß des Rangstellenindikators geordnet ist, der ihnen jeweils zugeordnet wurde.

## Claims

1. An arrangement for variable-length encoding of digital signals, divided into N parallel paths, successively comprising in each path quantization means, variable-length encoding means and rate control means including buffer memories, characterized in that it also comprises routing means which, after classification of the encoded signals in accordance with their increasing or decreasing lengths and classification of the buffer memories in accordance with their decreasing or increasing filling states, apply the encoded signals having the largest length to the buffer memories which are least filled, and add to the encoded signals a path indicator indicating their origin, said routing means being arranged between said variable-length encoding means and said rate control means.

2. An arrangement for variable-length encoding as claimed in Claim 1, successively comprising a circuit for demultiplexing the sequence of input signals into N sub-sequences applied to N parallel outputs of said circuit, N parallel paths for variable-length encoding of said N respective sub-sequences, and a circuit for multiplexing the N sub-sequences of the signals thus encoded and applied to the outputs of said N paths, said paths each comprising a circuit for quantizing the input signals of the path, a circuit for variable-length encoding of the signals thus quantized and a rate control circuit associating with a buffer memory a feedback connection connecting said memory and the quantization circuit, characterized in that it comprises:

(A) at the output of the encoding subassembly constituted by the N variable-length encoding circuits, a circuit for classifying the encoded signals as a function of their length;

(B) at the output of the rate control sub-assembly constituted by the N rate control circuits, a circuit for classifying the buffer memories in accordance with their filling state;

(C) between said encoding sub-assembly and said rate control subassembly a routing circuit for applying, in response to a control circuit, the encoded signal corresponding to the one having the smallest length to the input of the buffer memory corresponding to the one which is most filled, the encoded signal corresponding to the one having the largest length to the input of the buffer memory corresponding to the one which is least filled, and, likewise, each of the encoded signals corresponding to the ones having increasingly larger lengths to each one of the inputs of the buffer memories corresponding to the ones which are less and less filled;

(D) at the output of the encoding subassembly, between this sub-assembly and said routing circuit, a delay sub-assembly comprising a delay circuit for each path and intended to ensure the synchronism of the encoded signals with the corresponding routing commands.

3. An encoding arrangement as claimed in Claim 2, characterized in that the rate control sub-assembly only comprises a single feedback connection connecting any one of the buffer memories to each quantization circuit.

4. An arrangement for variable-length decoding in N parallel decoding paths, each successively comprising storage means succeeded by variable-length decoding means and subsequent inverse quantization means, said decoding relating to digital signals which have been previously variable-length encoded in N parallel encoding paths each successively comprising quantization means, variable-length encoding means, rate control means including buffer memories, as well as means for routing the encoded signals to the buffer memories which are less filled as the encoded signals are longer, said routing means being arranged between said variable-length encoding means and said rate control means, characterized in that said encoded signals are regrouped into data blocks accompanied by a path indicator for said blocks, and in that said decoding arrangement also comprises, at the output of said inverse quantization means, means for routing said blocks as a function of the associated path indicator.

5. A variable-length decoding arrangement as claimed in Claim 4, successively comprising a circuit for demultiplexing the sequence of input signals into N sub-sequences applied to N parallel outputs of said circuit, N parallel paths for variable-length decoding of said respective sub-sequences, said paths each comprising a buffer memory for storing the input signals of the path, a circuit for variable-length decoding of the signals thus quantized and a circuit for inverse quantization of the signals thus decoded, characterized in that said routing means comprise:

(a) a switching circuit having N switches with one input and N outputs, whose N respective positions are determined by means of N elements for transcoding the path indicator associated with each block;

(b) a transcoding circuit regrouping said transcoding elements;

(c) between the N inputs of said routing means and the N respective inputs of said switching circuit, a delay circuit having N delay elements associated with each respective path;

(d) a multiplexing circuit having N inputs connected, respectively, to one of the N outputs of said switches, said circuit being provided for supplying a continuous sequence of blocks arranged in accordance with the associated path indicator.

FIG.1

FIG.2a

FIG.2b

FIG.2c

EP 0 442 548 B1

FIG.3

FIG.4

EP 0 442 548 B1

FIG.5

FIG.6

FIG.7